(19) Europäisches Patentamt
European Patent Office
Office européen des brevets

(11) **EP 2 071 547 B1**

(12) **EUROPEAN PATENT SPECIFICATION**

(45) Date of publication and mention
of the grant of the patent:
**20.03.2013 Bulletin 2013/12**

(51) Int Cl.:
***G09F 9/33*** *(2006.01)*     ***G09F 13/22*** *(2006.01)*

(21) Application number: **08170076.7**

(22) Date of filing: **27.11.2008**

(54) **Display devices**

Anzeigevorrichtungen

Dispositifs d'affichage

(84) Designated Contracting States:
**DE FR GB**

(30) Priority: **11.12.2007 JP 2007319622**

(43) Date of publication of application:
**17.06.2009 Bulletin 2009/25**

(73) Proprietor: **Nichia Corporation**
**Anan-Shi, Tokushima 774-8601 (JP)**

(72) Inventor: **Takahashi, Tsuzuki**
**Anan-shi Tokushima 774-8601 (JP)**

(74) Representative: **Fenlon, Christine Lesley**
**Haseltine Lake LLP**
**Lincoln House, 5th Floor**
**300 High Holborn**
**London WC1V 7JH (GB)**

(56) References cited:
**JP-A- 11 305 689**     **JP-A- 2000 181 363**
**JP-A- 2006 243 418**     **US-A1- 2003 058 643**
**US-A1- 2003 231 151**

## Description

## BACKGROUND OF THE INVENTION

### 1. Field of the Invention

The present invention relates to a display device, and more particularly to a display device in which a plurality of light emitting elements are arranged in a matrix.

### 2. Background Information

Exterior-use display devices in which a plurality of light emitting elements are arranged in a matrix and various graphics or text is displayed have been in use for some time. With such a display device, it is known that incoming light incident at the face where the light emitting elements are disposed is reflected in the display observation direction, which decreases the contrast of the display device itself.

Various approaches have been adopted to minimize this decrease in contrast. For instance, a display device has been proposed that comprises a main canopy formed above the light emitting elements, and an auxiliary canopy provided separately from this main canopy (for example, see Japanese Laid-open Patent Application No. H11-305689 and 2001-56647, etc.,).

US 2003/0231151 A1 discloses a display device having a light shade mounted above each pixel group for reducing and preventing reflection of downwardly cast ambient light received. Narrow crevices with acutely angled opposite light reflective surfaces receive and reflect downwardly cast ambient light toward the narrow crevice formed where each pair of light reflective surfaces join. Adjacent pairs of opposed light reflective surfaces join at a plurality of sharp edges which in side view has the configuration of a series of "WWW".

JP 2006 1243418 discloses a display device having eaves, arranged between rows of pixels, and light shield portions projecting above the eaves. Each light shield portion has a first slope slanting obliquely downward on the side of pixels and a second slope on the side of the eave arranged below the light shield portion such that the angle formed between the first slope and a substrate of the light shield portion is larger than the angle formed between the second slope and the substrate of the light shield portion.

For example, the above described display device comprises a wiring board having means for driving light emitting elements, and a base or the like on which light emitting elements are arranged and fixed in a dot matrix, and the display device face comprises a main canopy for blocking incoming light from diagonally above the light emitting elements, and an auxiliary canopy located under the light emitting elements for minimizing surface reflection from the base.

With conventional display devices, however, it is not currently possible to obtain good contrast by adequately reducing the effect of sunlight or other such incoming light while ensuring a good viewing angle from below the display device.

That is, with the above-mentioned display device, if an attempt is made to ensure a good viewing angle from below the display device, the pixels and the auxiliary canopy have to be separated by a specific distance. Consequently, this increases the region between the pixels and the auxiliary canopy where incident light from the outside can be reflected in the display observation direction, and this leads to a decrease in contrast. Furthermore, no method has been found for adequately reducing the reflection of incoming light between the auxiliary canopy and the main canopy.

## SUMMARY OF THE INVENTION

It is desirable to provide a display device in which a viewing angle from below the display device is ensured while light reflected in the emission observation direction is kept to a minimum and contrast is adequately increased.

According to the present invention there is provided a display device in which pixels constituted by light emitting elements arranged on a substrate are arranged in a matrix, the substrate comprising: a canopy disposed at an upper end of the pixels; and at least two kinds of anti-reflective components that are formed at a peripheral edge of the light emitting element and with different reflection angles with respect to incident light; characterized in that the said at least two kinds of anti-reflective components comprise a first anti-reflective component disposed on the side of the element near the upper end canopy, and a second anti-reflective component disposed on the side of the element far from the upper end canopy, wherein: each of the first and second anti-reflective components comprises a first slanted face disposed on the side of the element near the upper end canopy, and a second slanted face disposed on the side of the element far from the upper end canopy, respectively, an angle of inclination ($\theta_{11}$) of the first slanted face of the first anti-reflective component with respect to the surface of the substrate is less than an angle of inclination ($\theta_{12}$) of the second slanted face of the first anti-reflective component with respect to the surface of the substrate, and an angle of inclination ($\theta_{21}$) of the first slanted face of the second anti-reflective component with respect to the surface of the substrate is greater than an angle of inclination ($\theta_{22}$) of the second slanted face of the second anti-reflective component with respect to the surface of the substrate.

With an embodiment of the present invention, light coming in from diagonally above the light emitting elements can be effectively blocked by a canopy, and reflection at the display face of a display device with which incoming light is incident from a relatively low angle, that is, reflection at the display face on the upper side within a unit pixel, can be efficiently suppressed by at least two kinds of anti-reflective component with different reflection angles with respect to incident light. This allows a good viewing angle from below the display device to be ensured while light reflected in the emission observation direction is kept to a minimum and contrast is adequately increased.

## BRIEF DESCRIPTION OF THE DRAWINGS

FIG. 1 is a front view of a display device embodying the present invention.
FIG. 2A is a detail front view of a main portion of FIG.1.
FIG. 2B is a cross-sectional view along the A-A' line of FIG. 2A.
FIG. 3 is a cross-sectional view of a main portion of a display device embodying the present invention describing a reflection of incoming light.
FIG. 4 is a cross-sectional view of a main portion of a display device embodying the present invention describing the formation region of the first anti-reflective component.

## DETAILED DESCRIPTION OF THE PREFERRED EMBODIMENTS

The best mode for carrying out the invention will now be described through reference to the drawings, but the mode described below merely exemplifies a display device for embodying the technological concepts of the present invention, and the present invention is not limited to the display device discussed below. Also, this Specification does not limit the members given in the Claims to the members of the embodiments. The sizes, materials, shapes, relative disposition, and so forth of the constituent members discussed in the embodiments are not unless, otherwise specified, intended to limit the scope of the invention to just those, and are merely given as descriptive examples. Furthermore, the size, positional relationships, and so forth of the members illustrated in the various diagrams may be exaggerated in order to make the description more clear. Also, in the following description, members that are the same or have the same properties are given the same names and numbers, and their detailed description may be omitted as appropriate. Furthermore, the various elements that make up the display device of the present invention may be in a mode such that a plurality of elements are constituted by the same member, and a plurality of elements all serve as a single member, or conversely, the function of a single member may be allocated to a plurality of members.

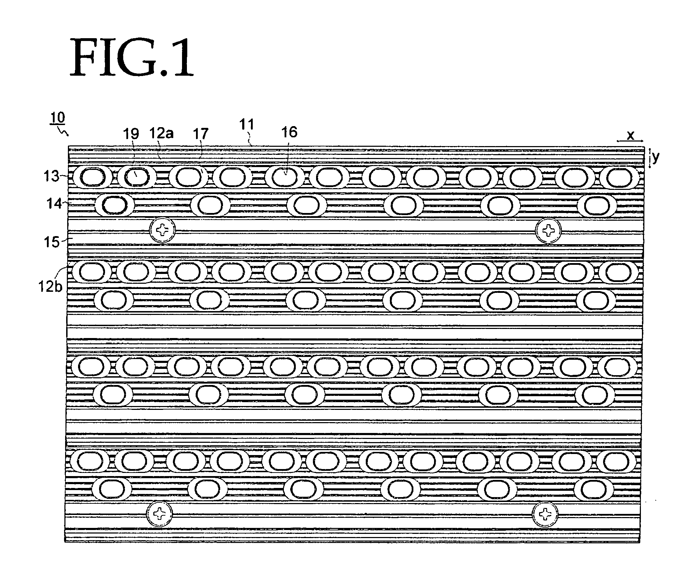

As shown in FIG. 1, for example, a display device embodying the present invention is mainly constituted by a substrate 11 and light emitting elements arranged on the substrate 11.

The role of the substrate 11 is to allow light emitting elements 19 to be disposed, fixed, etc., in a matrix in pixel units. The substrate 11 comprises canopies 12a and 12b disposed at the upper end and/ or lower end of the pixels in order to suppress the direct irradiation of the light emitting elements with sunlight or other such incoming light, and at least two kinds of anti-reflective components that are formed at a peripheral edge of the light emitting element and with different reflection angles with respect to incident light. A canopy is to be present at least at the upper end of one unit of the repeating structure discussed below, and if a canopy is also present at the lower end, is may also serve as the upper end canopy for the adjacent row below. As shown in FIG. 1, when the canopy 12a, a first anti-reflective component 13, a second anti-reflective component 14, a light blocking component 15, a canopy 12b, and so forth are arranged in that order starting at the top (that is, in the y direction in FIG. 1), the upper end of the pixels refers to the region in which the canopy 12a adjacent to the first anti-reflective component 13 is disposed in a single unit of the repeating structure (the canopy 12a, the first anti-reflective component 13, the second anti-reflective component 14, and the light blocking component 15).

The canopies 12a and 12b can be attached to the upper end and/or lower end of the pixels, either perpendicular to the surface of the substrate 11 or slanted to the perpendicular (such as a slant of about $\pm10°$ in the up and down direction, and preferably within $10°$ in the downward direction), according to the place where the display device is to be installed. Also, if a plurality of pixels are arranged in columns and rows in the display device, the canopies 12a and 12b are disposed continuously, going straight in the left and right direction (that is, the x direction in FIG.1), at the upper and lower ends of the pixels.

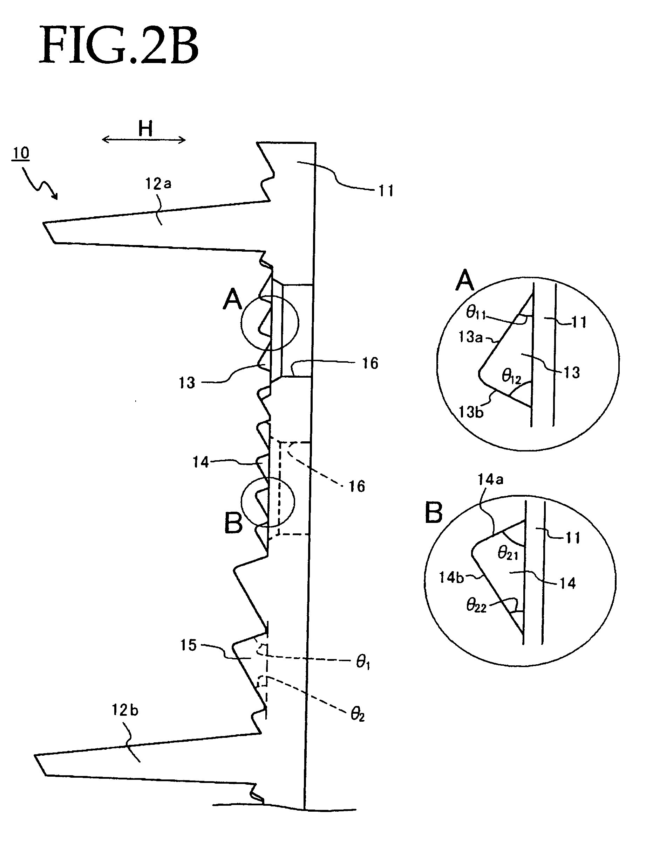

There are no particular restrictions on the size and shape of the canopies 12a and 12b as long as they function to effectively block incoming light from diagonally above the light emitting elements, and their size and shape can be suitably adjusted according to the size (pitch) of the pixels, the performance to be obtained for the display device, the intended application, the installation location, and so forth. For example, in the case of a display device to be used outdoors, the pitch of the pixels is preferably about 10 mm, about 12 mm, about 15 mm, about 16 mm, about 20 mm, about 25 mm, about 30 mm and the like, the height (the height in the direction of H in FIG. 2B, the same meaning below) is preferably about 3.0 mm to about 16.0 mm. The canopies 12a and 12b may also have mutually different heights.

Also, the canopies 12a and 12b may be formed integrally with, and from the same material as, the substrate 11, along with the anti-reflective components and/or the light blocking components, or may be formed separately and combined with the substrate 11.

The anti-reflective components 13 and 14 are formed at the peripheral edges of the light emitting elements 19, and usually, when pixels are arranged in a plurality of rows and columns in a display device, these anti-reflective components 13 and 14 are disposed continuously, going straight in the left and right direction, just as with the above-mentioned canopies 12a and 12b, and are disposed parallel to the canopies 12a and 12b.

At least two kinds (that is, three kinds, four kinds, or five or more kinds) of the anti-reflective components can be formed so that they have different reflection angles with respect to incident light, but two kinds are preferable when we take into account the complexity of the manufacturing process, the effect of suppressing undesired reflection to the display observer, and so forth.

The two or more kinds of anti-reflective components may be suitably distributed within a unit pixel, but as shown in FIG. 1, for example, a plurality may be disposed parallel to each other in the up and down direction (that is, in the y direction in FIG. 1), and may be disposed so as to have different reflection angles with respect to incident light on row-to-row. For example, if there are two kinds of anti-reflective components with different reflection angles with respect to incident light, it is preferable if a plurality of upper rows and a plurality of lower rows are disposed so as to have different reflection angles. The result is that the reflection of light from the display face can be distributed up or down according to the movement of incoming light (sunlight) whose incidence angle to the display device varies, so reflected light traveling in the line of sight of the display observer can be further reduced.

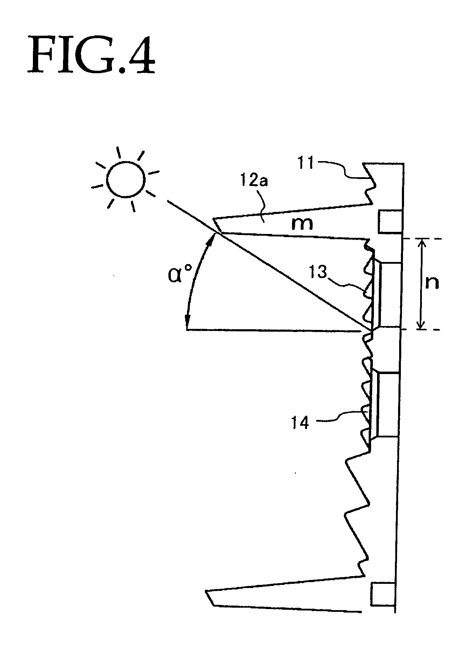

For instance, if two kinds of anti-reflective components are formed having different reflection angles with respect to incident light, usually there will be a first anti-reflective component 13 disposed on the side near the upper end canopy 12a, that is, on the upper side, and a second anti-reflective component 14 disposed on the far side, that is, on the lower side. There are no particular restrictions on the region in which the first anti-reflective component 13 is formed, which can be suitably adjusted after taking into account the height of the upper end canopy 12a, the incidence angle to the display device of incoming light that produces the reflected light to be suppressed, and so forth. For example, as shown in FIG. 4, if m be the height of the upper end canopy 12a, and $\alpha°$ be the incidence angle to the display face of the display device of incoming light that produces the reflected light to be suppressed, then the length n of the region in which the first anti-reflective component is formed from the upper end canopy 12a (that is, the length in the up and down direction of the region in which the first anti-reflective component is formed) can be found as m■tan$\alpha°$. The angle $\alpha$ here can be suitably adjusted depending on the angle of inclination of first and second slanted faces forming the first anti-reflective component 13 (disposed on the upper side) and the second anti-reflective component 14 (disposed on the lower side), and on the position of the display observer, but a relatively small value is favorable. For example, taking into account such factors as the relationship between sunlight and the location where the display device is installed, an angle no greater than 45°, no greater than 35°, no greater than 30°, no greater than 25° or no greater than 20° is preferable.

As shown inside the circle A in FIG. 2B, the first anti-reflective component 13 comprises a first slanted face 13a disposed on the side near the upper end canopy 12a (that is, the upper side), and a second slanted face 13b disposed on the far side (that is, the lower side). Taking into account the position of the display observer with respect to the display device, and the minimum amount of reflected light traveling in the line of sight of the display observer, the first and second slanted faces 13a and 13b are slanted faces with different angles of inclination.

In particular, the angle of inclination ($\theta_{11}$) of the first slanted face 13a with respect to the surface of the substrate 11 is less than the angle of inclination ($\theta_{12}$) of the second slanted face 13b with respect to the surface of the substrate 11. Examples of the ranges of $\theta_{11}$ and $\theta_{12}$ are $25° \leq \theta_{11} \leq 45°$ and $65° \leq \theta_{12} \leq 85°$, respectively.

As shown inside the circle B in FIG. 2B, the second anti-reflective component 14 favorably comprises a first slanted face 14a disposed on the side near the upper end canopy 12a (that is, the upper side), and a second slanted face 14b disposed on the far side (that is, the lower side). Taking into account the position of the display observer with respect to the display device, and the minimum amount of reflected light traveling in the line of sight of the display observer, the first and second slanted faces 14a and 14b are slanted faces with different angles of inclination.

In particular, the angle of inclination ($\theta_{21}$) of the first slanted face 14a with respect to the surface of the substrate 11 is greater than the angle of inclination ($\theta_{22}$) of the second slanted face 14b with respect to the surface of the substrate 11. Examples of the ranges of $\theta_{21}$ and $\theta_{22}$ are $65° \leq \theta_{21} \leq 85°$ and $25° \leq \theta_{22} \leq 45°$, respectively.

Subject to the above-mentioned restrictions, the angles of inclination $\theta_{11}$, $\theta_{22}$, $\theta_{12}$, and $\theta_{21}$ of the slanted faces of the anti-reflective components 13 and 14 with respect the surface of the substrate 11 may be different from each other, or some may be the same and some different, but it is particularly favorable if $\theta_{11}$ and $\theta_{22}$ are the same and/or $\theta_{12}$ and $\theta_{21}$ are the same. The result of this is that the manufacturing process will be simpler, while the obtained anti-reflection effect can be maximized.

The shape of the anti-reflective components 13 and 14 in an embodiment of the present invention need not be one that is triangular in cross section and constituted by first and second slanted faces. For example, the boundary portion between the first slanted face and the second slanted face (the distal end or corner portion) may have a specific curvature, and the first slanted face and/or the second slanted face may be a curved face. Also, the anti-reflective components 13 and 14 are favorably all the same height, but may be different from one another, or may all be individually different.

The substrate 11 preferably further comprises a light blocking component 15. Providing the light blocking component 15 allows reflection of incoming light to be reduced at the display observation face of the display device regardless of the pitch of the pixels.

The light blocking component 15 is preferably formed on the lower side of the light emitting elements and the lower end side in a single unit of the repeating structure. In other words, it is preferably formed on the lower side of the above-mentioned anti-reflective components 13 and 14. There are no particular restrictions on the size or shape of the light blocking component 15, but for example, it preferably has the first slanted face and second slanted face described for the anti-reflective components 13 and 14, and the height thereof is preferably shorter than that of the canopies 12a and 12b and taller than that of the anti-reflective components 13 and 14. This allows any incoming light reflected by the second slanted face to be reflected by the canopy at the adjacent pixels disposed below, so this light will not be observed in the display observation direction, and a good viewing angle from under the display device can also be ensured, and the resulting display device will have high contrast. More specifically, the difference between the height of the canopy and the height of the light blocking component is preferably about 5 to 10 mm, about 5.9 to 7.2 mm or about 8.0 to 8.6 mm.

The angles of inclination of the first and second slanted faces ($\theta_1$ and $\theta_2$, respectively) with respect to the substrate surface can be within the same ranges of angle as given above for $\theta_{11}$, $\theta_{22}$, $\theta_{12}$, and $\theta_{21}$, respectively, but they preferably satisfy $\theta_1 > \theta_2$, and more specifically, when $\theta_1$ is about 60 to 65°, $\theta_2$ is preferably about 40 to 53°, further, when $\theta_1$ is about 70 to 75°, $\theta_2$ is preferably about 27 to 32°. This will efficiently reduce the reflection of incoming light in the emission observation direction at the surface of the light blocking component and the face where the light emitting elements are disposed, affording a display device with high contrast.

Also, the substrate 11 preferably has a track-shaped flat portion 17 around the light emitting elements. The phrase "around the light emitting elements" as used here means the outer peripheral portion substantially adjacent to the light emitting elements, and the outer peripheral portion preferably has a track shape that is about 5 to 60% the width, or about 5 to 30% the width of the longest diameter of the light emitting elements as seen from the display side of the display device, for example. The "flat portion 17" refers to a state of being free of the bumps that constitute the above canopy, the light blocking component and the anti-reflective component, but encompasses a state in which the reflection of incoming light can be suppressed by fine texturing as will be discussed below. The effect of disposing this flat portion 17 around the light emitting elements is that the anti-reflective components protruding from the emission face do not narrow the viewing angle in the left and right direction (the x direction in FIG. 1), and a good viewing angle in the left and right direction can thus be ensured.

The substrate 11 can be formed from a plastic (polycarbonate resin, ABS resin, epoxy resin, phenol resin, etc.), a glass, a ceramics, a metal (simplex of aluminum, cupper, etc. and an alloy of metals thereof including Mg, Si, Fe, Cu, Mn, Cr, Zn, Ni, Ti, Pb, Sn, etc.) or the like, or from a material that combines these materials, but a plastic, and especially a polycarbonate containing glass fibers, is preferable because weatherproofness and mechanical strength can be improved relatively easily. Also, it is a relatively simple matter to color the substrate itself to black or another dark color by adding a colorant.

At least the display face of the display device substrate has fine texturing on its surface. This fine texturing reduces the gloss of the overall surface of the substrate, scatters incoming light, and minimizes the decrease in contrast that occurs when incoming light is reflected directly to the viewer side. This fine texturing can be obtained by delustering, pore formation, or other such machining or processing. For example, it can be obtained by sandblasting the surface of the substrate, coating it with a paint containing microscopic filler particles (such as silicon oxide), using a porous ceramic, etc., or another such method.

This fine texturing preferably has an average roughness (Ra) between 1 and 50 $\mu$m, preferably between 2 and 10 $\mu$m as calculated under the conditions set forth in JIS B 0601, at a roughness curve cut-off value ($\lambda$c) of 0.8 mm and a roughness curve reference length of 2.40 mm. The ten-point average roughness (Rz) is preferably between 5 and 100 $\mu$m, and more preferably between 10 and 50 $\mu$m.

A single unit of pixels constituted by the light emitting elements arranged on the substrate may be constituted by one light emitting element, that is, a light emitting element of a single color, but usually in the case of a color display, it is preferably constituted by three or more light emitting elements, namely, red (R), blue (B), and green (G). The number of light emitting elements can be suitably adjusted according to the brightness of the elements required in the display device. For instance, one pixel is constituted by arranging one light emitting element that emits red light, one light emitting element that emits green light, and one light emitting element that emits blue light. Alternatively, a single pixel may be constituted by arranging one light emitting element that emits red light, two light emitting elements that emit green light, and one light emitting element that emits blue light. The pattern in which the light emitting elements are laid out within the pixel can be suitably selected by taking display quality into account. For example, with the display device shown in FIG. 1, red and green light emitting elements are disposed one on the right and one on the left on the canopy 12a side, while a blue light emitting element is disposed underneath, that is, on the canopy 12b side, thereby constituting a single pixel in the shape of an inverted triangle. When a single pixel is constituted by four light emitting elements (not shown), for example, red and green light emitting elements may be disposed one on the right and one on the left on the canopy 12a side, while green and blue light emitting elements are disposed underneath, that is, one on the right and one on the left on the canopy 12b side, thereby constituting a single pixel in the shape of a square, with two rows and two columns. Furthermore, with the display device in FIG.1, pixels are disposed in a matrix of four rows and six columns on the substrate.

A variety of light emitting elements, such as LED chips and laser diodes (LD) can be utilized as the light emitting elements. An example of light emitting elements that can be used favorably is one in which semiconductor light emitting elements are disposed on lead electrodes in a package, etc., are electrically connected with lead electrodes, and then are covered with a resin or other such translucent member.

An LED chip, which can be used favorably as a semiconductor light emitting element, may be a single type that emits light in a single color, or a plurality may be used to emit light in one or more colors. For example, it is preferably the elements in which a light emitting layer is formed of a semiconductor such as ZnS, SiC, GaN, GaP, InN, AIN, ZnSe, GaAsP, GaAlAs, InGaN, GaAlN, AlInGaP, AlInGaN, etc, on the substrate by liquid phase growth method, HDVPE method, MOCVD method, and the like. The emission wavelength can be variously selected, from ultraviolet light to infrared light, depending on the material of the semiconductor layer, the degree of crystal mixing, and so forth. In particular, when the display device is to be one that can be used favorably outdoors, light emitting elements capable of emitting very bright light are needed. In view of this, a gallium nitride compound semiconductor is preferably selected as the material of light emitting elements that emit bright light in blue and green. A semiconductor based on gallium-aluminum-arsenic or a semiconductor based on aluminum-indium-gallium-phosphorus is preferably selected as the material of light emitting elements that emit light in red. The light emitting elements can also comprise a combination of a nitrogen compound semiconductor with phosphorescent materials that are excited by the emission wavelength of this semiconductor and that emit light in various colors.

For a color display device, it is preferably a combination of LED chips which are chips having a 610 to 700 nm of red light emitting wavelength, a 495 to 565 nm of green light emitting wavelength, and a 430 to 490 nm of blue light emitting wavelength, respectively.

Also, forming the resin or other such translucent member in the desired shape can provide a lens effect that focuses or diffuses light emitted from the light emitting elements. More specifically, examples include an oval shape, convex lens shape, or concave lens shape for widening the viewing angle in the horizontal direction, and shapes that combine a plurality of these. Furthermore, the package can contain a coloring pigment, coloring dye, or the like, and thereby provide the function of a filter that cuts out undesired wavelengths.

Through-holes corresponding to the diameter of the packaged light emitting elements are made in the substrate 11, and the emission faces of the light emitting elements are exposed through these holes on the surface side of the substrate 11. Also, the substrate is preferably provided with a mounting board that is electrically and/or mechanically connected with the light emitting elements on the opposite side from the side on which the light emitting elements are fixed (the display observation face side), means for driving the light emitting elements, a case for fixing and protecting the mounting board and/or a circuit board from the external environment, and so forth.

For example, the mounting board has light emitting elements arranged and fixed thereon, and has conductor wiring for supplying electrical power to these light emitting elements. The lead electrodes of the light emitting elements are electrically and mechanically connected to the mounting board by solder or another such electroconductive member. The mounting board on which the light emitting elements are disposed is a member on which the light emitting elements are disposed in the desired shape, and is used for electrically connecting to a conductive pattern such as copper foil provided to a substrate board, and also serves as a substrate board on which a drive means is disposed. The substrate board is preferably one with high mechanical strength and one that undergoes little thermal deformation. More specifically, a printed substrate made with ceramic, glass, an aluminum alloy, or the like can be used to advantage. Of the substrate board surface, the surface on the side on which the light emitting elements are mounted may be disposed on the display face side of the display device, and exposed from part of the substrate, so it is preferably colored black to improve contrast. The substrate board surface has preferably undergone texturing or graining, as this improves adhesion to the substrate, etc.

The drive means has a drive circuit for applying voltage to the light emitting elements, etc., and is used to control the lighting of the light emitting elements. Further, the drive means is electrically connected with the mounting board on which the light emitting elements are arranged and fixed.

More specifically, with a dynamically driven display device, the light emitting elements laid out in a matrix are driven by output pulses from the driven means. A drive circuit such as this can be constituted by a storage means for temporarily storing inputted display data, a gradation control circuit for computing a gradation signal for lighting the light emitting elements at specific times based on the data stored in the storage means, and a driver that is switched by output signals from the gradation control circuit and thereby lights the light emitting elements. For instance, the light emitting elements are lighted when the driver is on, and extinguished when the driver is off. The desired video data or the like can be displayed by controlling how long the various light emitting elements are lit. Also, display data can be inputted to the drive circuit by a central processing unit or the like.

The case is used to mechanically protect the light emitting elements arranged in a matrix on the wiring board, the substrate board on which the drive circuit is disposed, and the like from the outside. The specific material of the case is preferably a polycarbonate resin, ABS resin, epoxy resin, phenol resin, or the like because they are easier to mold. The internal surface of the case is preferably textured or subjected to a plasma treatment.

When a case is used, it holds in its interior the substrate on which the light emitting elements are arranged and fixed, the substrate on which the drive circuit is provided, and so forth, and is usually covered with a filler material. The filler material, for example, covers the lead electrodes exposed from the sealing member of the light emitting elements or the substrate on which the light emitting elements are fixed, and preferably has good adhesion with the light emitting elements, the case, the wiring board on which the light emitting elements are disposed, the substrate, and so forth. Specific examples of the filler material include one or more types selected from among epoxy resins, urethane resins, and silicone resins. To improve contrast, these resins may contain a black or other dark-colored dye or pigment. Furthermore, a thermal conduction member may be contained for the purpose of improve thermal conductivity. This thermal conduction member is preferably one that is not electrically conductive, because it is disposed between the light emitting elements. Specific examples include copper oxide and silver oxide.

Examples of a display device embodying the present invention will now be described through reference to the drawings.

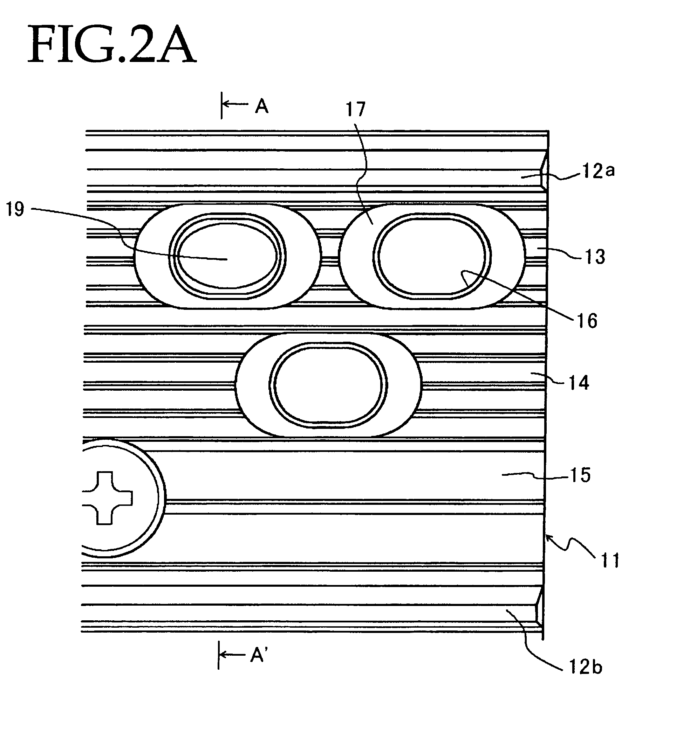

FIG. 1 is a front view of the display device 10 in this example. FIG. 2A is a detail front view of the display device, and FIG. 2B is a cross section along the A-A' line in FIG. 2A.

This display device 10 comprises a mounting board (not shown) that is electrically and mechanically connected to the light emitting elements, a circuit board (not shown) having a drive circuit that is a means for driving the light emitting elements, a case (not shown) for protecting the mounting board and the circuit board from the external environment, a substrate 11, and light emitting elements 19.

As shown in FIG. 2A, the substrate 11 has through-holes 16 for exposing the light emitting elements 19 on the display face side, and canopies 12a,12b, ..., a first anti-reflective component 13, a second anti-reflective component 14, and a light blocking component 15 are integrally disposed. The entire display face of the substrate 11, including the canopies 12a and 12b, the first anti-reflective component 13, the second anti-reflective component 14, and the light blocking component 15, is finely textured by delustering. A track-shaped flat portion 17 is provided around the outer periphery of the light emitting elements 19, in a width of 0.5 to 2.0 mm, and while this part is finely textured, it is free of relatively large bumps such as the canopies 12a and 12b, the first anti-reflective component 13, the second anti-reflective component 14, and the light blocking component 15.

The substrate 11 is attached, along with the light emitting elements 19 disposed on the mounting board, to a case (not shown) formed from polycarbonate containing glass fibers. The inside of the case is filled with silicone rubber so that part of the mounting board and the lead frame portion of the light emitting elements will be covered, except for the distal ends of the light emitting elements 19. The light emitting elements are electrically connected to the drive circuit.

A structure unit in the display device 10 consists of the substrate 11, which comprises the upper end canopy 12a, the lower end canopy 12b, the first anti-reflective component 13, the second anti-reflective component 14, and the light blocking component 15, and pixels of the light emitting elements 19 arranged in groups of three through the through-holes 16 on the substrate 11. The pitch of the pixels is set to 25 mm, for example.

The canopies 12a and 12b are disposed at the upper and lower ends of the pixels so as to extend in the left and right direction (the x direction in FIG. 1) of these pixels arranged in a matrix. The pitch of the canopies 12a and 12b is 25 mm and their height is 10.6 mm, for example.

Two kinds of anti-reflective components are formed: the first anti-reflective component 13, which is disposed on the side nearer the upper end canopy 12a, and the second anti-reflective component 14, which is disposed on the side farther away. At least one of each of these anti-reflective components 13 and 14, such as 3.5 and 5 of them, respectively, are disposed extending in the left and right direction of the pixels arranged in a matrix. The pitch of the anti-reflective components 13 and 14 is 1.6 mm and their height is 0.6 mm, for example.

The first anti-reflective component 13 comprises a first slanted face 13a disposed on the side near the canopy 12a at the upper end of the pixels, and a second slanted face 13b disposed on the side farther away, so that the first anti-reflective component 13 has a triangular cross sectional shape with an apex angle of 80°.

Also, the angle of inclination ($\theta_{11}$) of the first slanted face 13a of the first anti-reflective component 13 with respect to the surface of the substrate 11 is set to about 30°, while the angle of inclination ($\theta_{12}$) of the second slanted face 13b with respect to the surface of the substrate 11 is set to 70°.

Even when the display observer is looking up at the display device from below, and when sunlight is shining on the surface of the display device at an angle of less than 90°, which is assumed as the most common scenario when sunlight shines on a display device, the first anti-reflective component 13 will allow the light to be reflected to the canopy 12a on the upper end side. Therefore, the light will not be reflected to the side of the display observer, who is looking up at the display device from below, and contrast can be improved.

The second anti-reflective component 14 comprises a first slanted face 14a disposed on the side near the canopy 12a at the upper end of the pixels, and a second slanted face 14b disposed on the side farther away, so that the second anti-reflective component 14 has a triangular cross sectional shape with an apex angle of 80°.

Also, the angle of inclination ($\theta_{21}$) of the first slanted face 14a of the second anti-reflective component 14 with respect to the surface of the substrate 11 is set to about 70°, while the angle of inclination ($\theta_{22}$) of the second slanted face 14b with respect to the surface of the substrate 11 is set to 30°.

Even when the display observer is looking up at the display device from below, and when sunlight is shining on the surface of the display device at an angle of less than 90°, which is assumed as the most common scenario when sunlight shines on a display device, the second anti-reflective component 14 will allow the light to be reflected to the canopy 12b on the lower end side. The range of the region in which the second anti-reflective component 14 is disposed is adjusted so that this reflected light will be blocked by the canopy 12b. Therefore, the light will not be reflected to the side of the display observer, who is looking up at the display device from below, and contrast can be improved.

The light blocking component 15 is disposed between the upper end canopy 12a and the lower end canopy 12b, extends in the same x direction as the canopies 12a and 12b, and is disposed under the pixels. The light blocking component 15 has a first slanted face near (facing) the upper end canopy 12a, and a second slanted face near (facing) the lower end canopy 12b, so that it has a triangular cross sectional shape with an apex angle of 78°. The result is that incoming light incident on these slanted faces can be reflected in a direction other than the display observation direction, so contrast can be further enhanced.

For example, the angles of inclination ($\theta_1$ and $\theta_2$ in FIG. 2B) of the first and second slanted faces with respect to the surface of the substrate 11 are set to 70° and 32°, respectively. The pitch between light blocking components 15 is 3.6 mm, and their height is 1.5 mm, for example.

Three LED chips capable of emitting green, blue, and red light are used as the light emitting elements. These LED chips have a semiconductor as the light emitting layer of InGaN (525 nm of wavelength), InGaN (470 nm of wavelength), AlGaInP (660 nm of wavelength), respectively. Each LED chip is die-bonded to a lead frame with silver paste, then wire bonded with gold wire, so that the LED chips and the lead frame are electrically connected. This product is then covered with an epoxy resin, forming a sealed member that is substantially oval in shape when viewed from the top of the sealed member.

These LED chips are made into sealed members with an oval cross section, and are arranged so that the major axis direction of this oval is the horizontal direction of the display device. The light emitting elements are disposed such that they are inclined by about 6° downward with respect to a perpendicular of the surface of the substrate 11.

The display device in this example is usually attached so that the up and down direction in FIG. 1 (the y direction) substantially coincides with the vertical direction, the horizontal direction coincides with the x direction, and the bottom of the display device faces the ground.

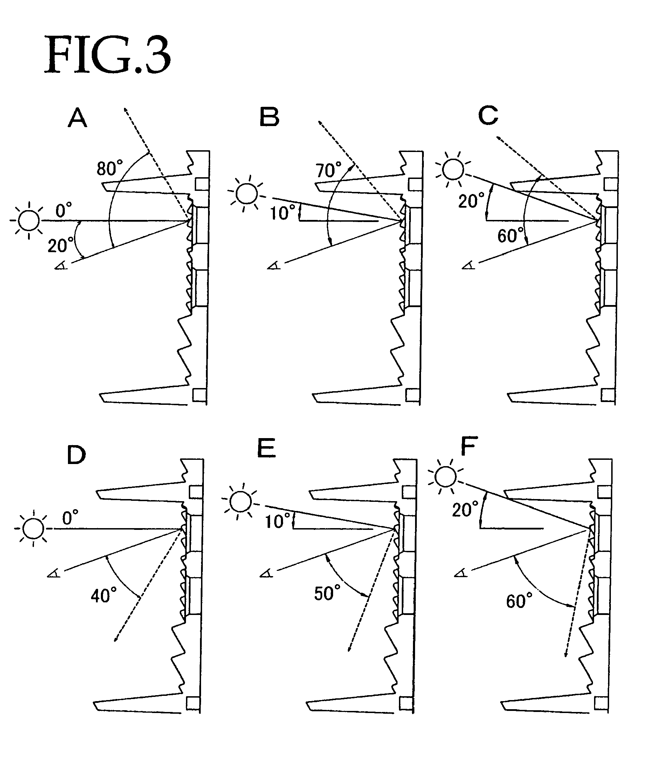

As shown in FIGS. 3A to 3C, with the display device 10 of this example constituted as above, when the angle of the line of sight of the display observer is set to 20° with respect to the perpendicular direction of the display face of the display device 10 (20° is a typical line of sight angle, assuming a common line of sight angle range), incoming light with a relatively small incidence angle of about 30° (and especially about 20°) from a perpendicular to the display face of the display device 10 can be reflected to the upper end canopy 12a over a range of 80° to 60°, so it can be seen that an extremely high contrast can be obtained.

Meanwhile, for the sake of comparison, as shown in FIGS. 3D to 3F, a display device that was the same as the display device in the above example was produced, except that the anti-reflective component was not divided into a first anti-reflective component and a second anti-reflective component, and bumps corresponding to the second anti-reflective component were formed. Just as above, when the angle of the line of sight of the display observer was set to 20° with respect to the perpendicular direction of the display face of the display device 10, incoming light with a relatively small incidence angle of about 30° from a perpendicular to the display face of the display device 10 will only be reflected to the lower end canopy 12b near the line of sight of the display observer over a smaller angle range of 40° to 60° than the one mentioned above (60° to 80°), and it can be seen that contrast will be lower than in the above example.

Also, in the example given above, both when the angle of the line of sight of the display observer is less than 20° with respect to the perpendicular direction of the display face of the display device 10, and when it is more than 20°, the angle of the line of sight of the display observer can be made to differ greatly with respect to reflection of incoming light with a relatively small incidence angle. In other words, the light can be reflected at an angle that is away from the line of sight of the display observer. Therefore, it is confirmed that higher contrast can be obtained.

Thus, with the display device of this example, a good viewing angle from below is ensured, while in the display observation direction there will be less reflection of light coming in from a relatively low direction, which is incident from between the horizontal direction and a diagonally upward direction, and this markedly improves contrast.

An embodiment of the present invention can be utilized as a display device for displaying color images by arranging a plurality of light emitting elements in a matrix, and in particular as a color display that gives a vivid image with high contrast even outdoors.

While only selected embodiments have been chosen to illustrate the present invention, it will be apparent to those skilled in the art from this disclosure that various changes and modifications can be made herein without departing from the scope of the invention as defined in the appended claims. Furthermore, the foregoing descriptions of the embodiments according to the present invention are provided for illustration only, and not for the purpose of limiting the invention as defined by the appended claims. Thus, the scope of the invention is not limited to the disclosed embodiments.

**Claims**

1. A display device (10) in which pixels constituted by light emitting elements (19) arranged on a substrate (11) are arranged in a matrix, the substrate (11) comprising:

   a canopy (12a) disposed at an upper end of the pixels (19); and
   at least two kinds of anti-reflective components (13, 14) that are formed at a peripheral edge of the light emitting element and with different reflection angles with respect to incident light;
   **characterized in that** the said at least two kinds of anti-reflective components (13, 14) comprise a first anti-reflective component (13) disposed on the side of the element (19) near the upper end canopy (12a), and a second anti-reflective component (14) disposed on the side of the element (19) far from the upper end canopy (12a), wherein:

   each of the first and second anti-reflective components (13, 14) comprises a first slanted face (13a, 14a) disposed on the side of the element (19) near the upper end canopy (12a), and a second slanted face (13b, 14b) disposed on the side of the element (19) far from the upper end canopy (12a), respectively,
   an angle of inclination ($\theta_{11}$) of the first slanted face (13a) of the first anti-reflective component (13) with respect to the surface of the substrate (11) is less than an angle of inclination ($\theta_{12}$) of the second slanted face (13b) of the first anti-reflective component (13) with respect to the surface of the substrate, and
   an angle of inclination ($\theta_{21}$) of the first slant-

   ed face (14a) of the second anti-reflective component (14) with respect to the surface of the substrate (11) is greater than an angle of inclination ($\theta_{22}$) of the second slanted face (14b) of the second anti-reflective component (14) with respect to the surface of the substrate (11).

2. The display device according to Claim 1,
   the angle of inclination ($\theta_{11}$) of the first slanted face (13a) of the first anti-reflective component (13) with respect to the surface of the substrate (11) is the same as the angle of inclination ($\theta_{22}$) of the second slanted face (14b) of the second anti-reflective component (14) with respect to the surface of the substrate (11), and
   the angle of inclination ($\theta_{12}$) of the second slanted face (13b) of the first anti-reflective component (13) with respect to the surface of the substrate (11) is the same as the angle of inclination ($\theta_{21}$) of the first slanted face (14a) of the second anti-reflective component (14) with respect to the surface of the substrate (11).

3. The display device according to Claim 1 or 2, wherein the first anti-reflective component (13) is formed in a region adjacent to the upper end canopy (12a), and the length n from the base of the upper end canopy (12a) in the region satisfies the equation:

$$n = m \cdot \tan \alpha°$$

   where m is the height of the upper end canopy (12a) with respect to the substrate (11), and $\alpha$ is the incidence angle of incoming light that produces reflected light when incident on the display device.

4. The display device according to any preceding Claim, wherein the substrate further comprises a light blocking component (15) that is shorter than a lower end canopy (12b) and taller than the anti-reflective components (13, 14) with respect to the substrate (11), on the lower end side within the pixels and the lower side of the light emitting elements (19).

5. The display device according to any preceding Claim, wherein the substrate (11) has a track-shaped flat portion (17) between the light emitting elements (19) and the first anti-reflective component (13) or the second anti-reflective component (14).

6. The display device according to any preceding Claim, wherein the surface of the substrate has been subjected to delustering, pore formation, or other such machining or processing.

**Patentansprüche**

1. Anzeigevorrichtung (10), in der Pixel, die von Licht aussendenden Elementen (19) gebildet werden, auf einem Substrat (11) in einer Matrix angeordnet sind, wobei das Substrat (11) umfasst:

eine Abschirmblende (12a), die am oberen Ende der Pixel (19) angeordnet ist; und
···mindestens zwei Arten reflexionshemmender Komponenten (13, 14), die an einer Randkante des Licht aussendenden Elements ausgebildet sind und die unterschiedliche Reflexionswinkel bezüglich des einfallenden Lichts aufweisen; **dadurch gekennzeichnet, dass** die mindestens zwei Arten reflexionshemmender Komponenten (13, 14) eine erste reflexionshemmende Komponente (13) umfassen, die an der Seite des Elements (19), die näher an der oberen Abschirmblende (12a) ist, angeordnet ist, und eine zweite reflexionshemmende Komponente (14), die an der Seite des Elements (19), die weiter entfernt von der oberen Abschirmblende (12a) ist, angeordnet ist, wobei:

sowohl die erste reflexionshemmende Komponente (13) als auch die zweite reflexionshemmende Komponente (14) eine erste geneigte Fläche (13a, 14a) umfassen, die auf der Seite des Elements (19) angeordnet ist, die näher an der oberen Abschirmblende (12a) ist, und eine zweite geneigte Fläche (13b, 14b), die auf der Seite des Elements (19) angeordnet ist, die weiter von der oberen Abschirmblende (12a) entfernt ist,
ein Neigungswinkel ($\theta_{11}$) der ersten geneigten Fläche (13a) der ersten reflexionshemmenden Komponente (13) bezogen auf die Oberfläche des Substrats (11) kleiner ist als ein Neigungswinkel ($\theta_{12}$) der zweiten geneigten Fläche (13b) der ersten reflexionshemmenden Komponente (13) bezogen auf die Oberfläche des Substrats, und
ein Neigungswinkel ($\theta_{21}$) der ersten geneigten Fläche (14a) der zweiten reflexionshemmenden Komponente (14) bezogen auf die Oberfläche des Substrats (11) größer ist als ein Neigungswinkel ($\theta_{22}$) der zweiten geneigten Fläche (14b) der zweiten reflexionshemmenden Komponente (14) bezogen auf die Oberfläche des Substrats (11).

2. Anzeigevorrichtung nach Anspruch 1, wobei der Neigungswinkel ($\theta_{11}$) der ersten geneigten Fläche (13a) der ersten reflexionshemmenden Komponente (13) bezogen auf die Oberfläche des Substrats (11) gleich dem Neigungswinkel ($\theta_{22}$) der zweiten geneigten Fläche (14b) der zweiten reflexionshemmenden Komponente (14) bezogen auf die Oberfläche des Substrats (11) ist, und der Neigungswinkel ($\theta_{12}$) der zweiten geneigten Fläche (13b) der ersten reflexionshemmenden Komponente (13) bezogen auf die Oberfläche des Substrats (11) gleich dem Neigungswinkel ($\theta_{21}$) der ersten geneigten Fläche (14a) der zweiten reflexionshemmenden Komponente (14) bezogen auf die Oberfläche des Substrats (11) ist.

3. Anzeigevorrichtung nach Anspruch 1 oder 2, wobei die erste reflexionshemmende Komponente (13) in einem Bereich nahe an der oberen Abschirmblende (12a) ausgebildet ist, und die Länge n vom Ansatz der oberen Abschirmblende (12a) in dem Bereich die Gleichung erfüllt:

$$n = m \cdot \tan \alpha°,$$

wobei m die Höhe der oberen Abschirmblende (12a) bezogen auf das Substrat (11) ist, und $\alpha$ der Einfallswinkel des einfallenden Lichts ist, das reflektiertes Licht erzeugt, wenn es auf die Anzeigevorrichtung fällt.

4. Anzeigevorrichtung nach irgendeinem vorhergehenden Anspruch, wobei das Substrat zudem eine Licht abhaltende Komponente (15) umfasst, die bezogen auf das Substrat (11) kürzer ist als eine Abschirmblende (12b) am unteren Ende und länger als die reflexionshemmenden Komponenten (13, 14), und zwar an der unteren Seite innerhalb der Pixel und der unteren Seite der Licht aussendenden Elemente (19).

5. Anzeigevorrichtung nach irgendeinem vorhergehenden Anspruch, wobei das Substrat (11) zudem einen schienenförmigen ebenen Abschnitt (17) zwischen den Licht aussendenden Elementen (19) und der ersten reflexionshemmenden Komponente (13) oder der zweiten reflexionshemmenden Komponente (14) aufweist.

6. Anzeigevorrichtung nach irgendeinem vorhergehenden Anspruch, wobei die Oberfläche des Substrats mattiert oder mit Poren versehen ist oder einer anderen derartigen Behandlung oder Verarbeitung unterzogen ist.

**Revendications**

1. Dispositif d'affichage (10), dans lequel des pixels formés par des éléments émetteurs de lumière (19) agencés sur un substrat (11) sont agencés en une matrice, le substrat (11) comprenant :

une structure (12a) disposée à une extrémité supérieure des pixels (19) ; et
au moins deux types de composants anti-réflectifs (13, 14) qui sont formés à un bord périphérique de l'élément émetteur de lumière et avec des angles de réflexion différents par rapport à la lumière incidente ;
**caractérisé en ce que** lesdits au moins deux types de composants antireflet (13, 14) comprennent un premier composant antireflet (13) disposé sur le côté de l'élément (19) à proximité de la structure (12a) à l'extrémité supérieure, et un deuxième composant antireflet (14) disposé sur le côté de l'élément (19) très éloigné de la structure (12a) à l'extrémité supérieure, dans lequel :

chacun des premier et deuxième composants antireflet (13, 14) comprend une première face inclinée (13a, 14a) disposée sur le côté de l'élément (19) près de la structure (12a) à l'extrémité supérieure, et une deuxième face inclinée (13b, 14b) disposée sur le côté de l'élément (19) très éloigné de la structure (12a) à l'extrémité supérieure, respectivement,
un angle d'inclinaison ($\theta_{11}$) de la première face inclinée (13a) du premier composant antireflet (13) par rapport à la surface du substrat (11) est plus petit qu'un angle d'inclinaison ($\theta_{12}$) de la deuxième face inclinée (13b) du premier composant antireflet (13) par rapport à la surface du substrat, et
un angle d'inclinaison ($\theta_{21}$) de la première face inclinée (14a) du deuxième composant antireflet (14) par rapport à la surface du substrat (11) est plus grand qu'un angle d'inclinaison ($\theta_{22}$) de la deuxième face inclinée (14b) du deuxième composant antireflet (14) par rapport à la surface du substrat (11).

2. Dispositif d'affichage selon la revendication 1, l'angle d'inclinaison ($\theta_{11}$) de la première face inclinée (13a) du premier composant antireflet (13) par rapport à la surface du substrat (11) est le même que l'angle d'inclinaison ($\theta_{22}$) de la deuxième face inclinée (14b) du deuxième composant antireflet (14) par rapport à la surface du substrat (11), et l'angle d'inclinaison ($\theta_{12}$) de la deuxième face inclinée (13b) du premier composant antireflet (13) par rapport à la surface du substrat (11) est le même que l'angle d'inclinaison ($\theta_{21}$) de la première face inclinée (14a) du deuxième composant antireflet (14) par rapport à la surface du substrat (11).

3. Dispositif d'affichage selon la revendication 1 ou 2, dans lequel le premier composant antireflet (13) est formé dans une région adjacente à la structure (12a) à l'extrémité supérieure, et la longueur n de la base de la structure (12a) à l'extrémité supérieure dans la région satisfait à l'équation :

$$n = m \cdot tan\ a°$$

où m est la hauteur de la structure (12a) à l'extrémité supérieure par rapport au substrat (11), et a est l'angle d'incidence de la lumière entrante qui produit la lumière réfléchie lorsqu'elle est incidente sur le dispositif d'affichage.

4. Dispositif d'affichage selon l'une quelconque des revendications précédentes, dans lequel le substrat comprend en outre un composant bloquant la lumière (15) qui est plus court qu'une structure (12b) à l'extrémité inférieure et plus grand que les composants antireflet (13, 14) relativement au substrat (11), sur le côté de l'extrémité inférieure dans les pixels et le côté inférieur des éléments émetteurs de lumière (19).

5. Dispositif d'affichage selon l'une quelconque des revendications précédentes, dans lequel le substrat (11) possède une portion plate en forme de piste (17) entre les éléments émetteurs de lumière (19) et le premier composant antireflet (13) ou le deuxième composant antireflet (14).

6. Dispositif d'affichage selon l'une quelconque des revendications précédentes, dans lequel la surface du substrat a été soumise à un délustrage, une formation de pores ou autre usinage ou traitement analogue.

# FIG.1

# FIG.2A

# FIG.2B

# FIG.3

# FIG.4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H11305689 B
- JP 2001056647 A
- US 20030231151 A1
- JP 20061243418 B